# EUROPEAN PATENT APPLICATION

(11) **EP 4 835 131 A1**
(43) Date of publication of application: **04.11.2026**
(21) Application number: 24912846.3
(22) Date of filing: 24.12.2024
(51) Int. Cl.: C23C 16/44, C01B 32/186, C23C 16/26, C23C 16/46

(54) **METHOD FOR PRODUCING GRAPHENE**

(30) Priority: 27.12.2023 JP 2023220821
(71) Applicant: AGC Inc., Chiyoda-ku Tokyo 100-8405 (JP)
(72) Inventor: YONETA, Kiyoto, Tokyo 100-8405 (JP); ONO, Masashi, Tokyo 100-8405 (JP); WATANABE, Hiroshi, Tokyo 100-8405 (JP); YASUI, Yoji, Tokyo 100-8405 (JP); YONEMICHI, Tomohiro, Tokyo 100-8405 (JP)
(74) Representative: Müller-Boré & Partner Patentanwälte PartG mbB
(86) International application number: PCT/JP2024/045762
(87) International publication number: WO 2025/142960

(57) **Abstract**

Provided is a method for producing graphene, in which uneven heating within a reaction chamber can be suppressed.

The method for producing graphene is carried out using a thermal CVD apparatus. The thermal CVD apparatus includes: a cylindrical reaction chamber configured to accommodate therein a substrate for graphene production; a gas supply unit connected to the reaction chamber to supply a source gas containing a hydrocarbon to the substrate accommodated in the reaction chamber; a gas exhaust unit connected to an opposite side of the reaction chamber from the gas supply unit to exhaust gas from inside the reaction chamber; a heater arranged to cover a region of the reaction chamber, including a region in which the substrate is accommodated, to heat the inside of the reaction chamber; and shielding members disposed in the reaction chamber to suppress heat transfer within the reaction chamber. The shielding members are arranged at least between the gas supply unit and the substrate and between the substrate and the gas exhaust unit. The method satisfies a relationship of the formula (x): $W / S \leq 54.97 \times exp \left\{-0.128\times \left(x-4.0\right)\right\}$ (x1) where W is the flow rate of the source gas introduced from the gas supply unit; S is the internal cross-sectional area of the reaction chamber; and x is the internal diameter of the reaction chamber.

## Description

### TECHNICAL FIELD

The present invention relates to a method for producing graphene using a thermal CVD (Chemical Vapor Deposition) apparatus.

### BACKGROUND ART

Graphene is a sheet-like material in which carbon atoms are bonded to each other via sp² bonds, and graphite is formed by stacking of graphene sheets. In graphene, a hexagonal lattice structure (hexagonal network) is composed of carbon atoms and their bonds.

Patent Document 1 discloses a method for producing graphene, including: oxidizing a surface of a substrate to form an oxide layer; and forming a nanocarbon material layer (graphene layer) on a surface of the oxide layer. More specifically, the disclosed method involves accommodating the substrate in a reaction chamber, supplying a gaseous carbon source into the reaction chamber, and heating the substrate within the reaction chamber to form a nanocarbon material layer on the oxide layer formed on the substrate.

The method for producing graphene as disclosed in Patent Document 1 falls under CVD techniques.

### PRIOR ART DOCUMENTS

### PATENT DOCUMENTS

Patent Document 1: JP-A-2021-178760

### DISCLOSURE OF INVENTION

### TECHNICAL PROBLEM

The present inventors have studied the production method disclosed in Patent Document 1 and have found that uneven heating may occur within the reaction chamber. The occurrence of uneven heating in the reaction chamber leads to problems in that graphene cannot be efficiently produced.

Such a decrease in graphene production efficiency may become more pronounced as the diameter of the reaction chamber increases.

The present invention has been made in view of the above-described problems. It is an object of the present invention to provide a method for producing graphene, in which uneven heating within a reaction chamber can be suppressed.

### SOLUTION TO PROBLEM

As a result of extensive studies on the above-described problems, the present inventors have found that uneven heating can be suppressed by controlling the flow rate of the source gas so as to satisfy a predetermined relationship between the gas flow rate and the internal cross-sectional area and internal diameter of the reaction chamber, and thus have arrived at the present invention.

Namely, the present inventors have found the following solutions to the above-described problems.
[1] A method for producing graphene using a thermal CVD apparatus,
   the thermal CVD apparatus comprising:
   a cylindrical reaction chamber configured to accommodate therein a substrate for graphene production;
   a gas supply unit connected to the reaction chamber to supply a source gas containing a hydrocarbon toward the substrate accommodated in the reaction chamber;
   a gas exhaust unit connected to an opposite side of the reaction chamber form the gas supply unit to exhaust gas from inside the reaction chamber;
   a heater arranged to cover a region of the reaction chamber, including a region in which the substrate is accommodated, to heat the inside of the reaction chamber; and
   shielding members disposed in the reaction chamber to suppress heat transfer within the reaction chamber, the shielding members being arranged at least between the gas supply unit and the substrate and between the substrate and the gas exhaust unit,
   the method satisfying a relationship of the formula (x1) described later where W is a flow rate of the source gas introduced from the gas supply unit; S is an internal cross-sectional area of the reaction chamber; and x is an internal diameter of the reaction chamber.
[2] The method for producing graphene according to [1], wherein:
   the shielding members include first, second, third, and fourth shielding members arranged inside the reaction chamber in order from a gas-supply-unit side to a gas-exhaust-unit side of the reaction chamber; and
   the second and third shielding members are positioned in the region of the reaction chamber covered by the heater; and
   the first and fourth shielding members are positioned in regions of the reaction chambers not covered by the heater.
[3] The method for producing graphene according to [2], wherein:
   each of the first, second, third, and fourth shielding members comprises either one shielding plate or two or more shielding plates;
   each shielding plate has one or more holes; and
   an opening ratio of each shielding plate relative to the internal cross-sectional area of the reaction chamber is 0.1 to 40%.
[4] The method for producing graphene according to [3], wherein:
   each of the first, second, third, and fourth shielding members comprises two or more shielding plates arranged at a constant interval d1; and
   a ratio D12/d1 of a distance D12 between the first and second shielding members to the interval d1, and a ratio D34/d1 of a distance D34 between the third and fourth shielding members to the interval d1, are each 0.03 to 52.88.
[5] The method for producing graphene according to [4], wherein:
   a ratio D12/L1 of the distance D12 between the first and second shielding members to L1, and a ratio D12/L2 of the distance D12 between the first and second shielding members to L2, are each 0.01 to 23.27; and
   a ratio D34/L3 of the distance D34 between the third and fourth shielding members to L3, and a ratio D34/L4 of the distance D34 between the third and fourth shielding members to L4, are each 0.01 to 23.27,
      where L1 is a length of the first shielding member;
   L2 is a length of the second shielding member;
   L3 is a length of the third shielding member; and
   L4 is a length of the fourth shielding member.
[6] The method for producing graphene according to [4] or [5], wherein:
   a value of X1H calculated by the following formula (1) using the distance D12 is 0.01 or greater; and
   a value of X4H calculated by the following formula (2) using the distance D34 is 0.01 or greater: $X 1 H = \left(D12-D1H\right) / D 12$ (1) $X 4 H = \left(D34-D4H\right) / D 34$ (2) where D1H is a distance from a gas-supply-unit-side end of the region covered by the heater to the first shielding member; and
   D4H is a distance from a gas-exhaust-unit-side end of the region covered by the heater to the fourth shielding member.
[7] The method for producing graphene according to [6], wherein the values of X1H and X4H are each 0.60 to 1.00.
[8] The method for producing graphene according to any one of [3] to [7], wherein:
   the opening ratio of the shielding plate in the first shielding member is greater than the opening ratio of the shielding plate in the second shielding member; and
   the opening ratio of the shielding plate in the fourth shielding member is greater than the opening ratio of the shielding plate in the third shielding member.
[9] The method for producing graphene according to any one of [3] to [8], wherein a product of the opening ratios of the shielding plates that constitute the first and second shielding members, respectively, and a product of the opening ratios of the shielding plates that constitute the third and fourth shielding members, respectively, are each 0.0009 to 0.0700%.
[10] The method for producing graphene according to any one of [3] to [9], wherein:
   the second shielding member comprises two or more shielding plates, including shielding plates with different opening ratios; and
   the third shielding member comprises two or more shielding plates, including shielding plates with different opening ratios.
[11] The method for producing graphene according to any one of [3] to [10], wherein:
   the second shielding member comprises two or more shielding plates, and the shielding plate of the second shielding member located closest to the third shielding member has an opening ratio smaller than that of the shielding plate of the second shielding member located closest to the first shielding member; and
   the third shielding member comprises two or more shielding plates, and the shielding plate of the third shielding member located closest to the second shielding member has an opening ratio smaller than that of the shielding plate of the third shielding member located closest to the fourth shielding member.
[12] The method for producing graphene according to any one of [3] to [11], wherein:
   the first shielding member comprises two or more shielding plates, and the shielding plate of the first shielding member located closest to the gas supply unit has an opening ratio smaller than that of the shielding plate of the first shielding member located closest to the second shielding member; and
   the fourth shielding member comprises two or more shielding plates, and the shielding plate of the fourth shielding member located closest to the gas exhaust unit has an opening ratio smaller than that of the shielding plate of the fourth shielding member located closest to the third shielding member.
[13] The method for producing graphene according to any one of [3] to [12], wherein the shielding plate comprises at least one selected from the group consisting of silicon oxide, silicon nitride, graphite, aluminum oxide, aluminum nitride, tantalum oxide, tantalum carbide, niobium oxide, niobium carbide, and molybdenum oxide.
[14] The method for producing graphene according to any one of [3] to [13], wherein the second and third shielding members are made of metal.
[15] The method for producing graphene according to any one of [1] to [14], wherein a value obtained by dividing a temperature measured at the following first position by a temperature measured at the following second position is 0.62 or greater,
   provided that:
   the first position is a position in an axial direction of the reaction chamber corresponding to a substrate-side surface of the first shielding member;
   the second position is a position in the axial direction of the reaction chamber corresponding to the center of the substrate; and
   the temperatures measured at the first and second positions are in units of °C.
[16] The method for producing graphene according to any one of [1] to [15], wherein the internal diameter of the reaction chamber is 12.7 to 38.1 cm.
[17] The method for producing graphene according to any one of [1] to [16], wherein the internal diameter of the reaction chamber is 15.24 to 35.56 cm.
[18] The method for producing graphene according to any one of [1] to [17], wherein the internal diameter of the reaction chamber is 20.32 to 30.48 cm.
[19] The method for producing graphene according to any one of [1] to [18], wherein the reaction chamber comprises silicon dioxide.
[20] The method for producing graphene according to any one of [1] to [19], comprising:
   accommodating a substrate in the reaction chamber, the substrate having a metal film containing at least one metal selected from the group consisting of copper, nickel, and iron;
   supplying a source gas containing a hydrocarbon from the gas supply unit into the reaction chamber; and
   heating the inside of the reaction chamber to 900 to 1,100°C by the heater, thereby forming graphene on the metal film.

### ADVANTAGEOUS EFFECTS OF INVENTION

According to the present invention, there is provided a method for producing graphene, in which uneven heating within a reaction chamber can be suppressed.

### BRIEF DESCRIPTION OF DRAWINGS

Fig. 1 is a schematic cross-sectional view of an embodiment of a thermal CVD apparatus used in the method for producing graphene according to the present invention.
Fig. 2A is a schematic cross-sectional view of a first shielding member 11.
Fig. 2B is a schematic view of the first shielding member 11, viewed from a gas supply unit 22 side.
Fig. 3 is a schematic cross-sectional view of a reaction chamber of the thermal CVD apparatus, taken at a portion corresponding to a shielding plate of the first shielding member.

### DESCRIPTION OF EMBODIMENTS

Hereinafter, embodiments of the present invention will be described with reference to the drawings. It should, however, be understood that the present invention is not limited to the following embodiments. Various changes, modifications, and substitutions can be made to the following embodiments without departing from the scope of the present invention.

The following terms used in the present specification are defined as follows.

In the present specification, a numerical range expressed using "to" indicates a range including the numerical values described before and after "to" as the lower and upper limits.

In the present specification, graphene includes not only single-layer graphene formed of a single graphene sheet, but also multilayer graphene formed by stacking of single graphene sheets. The number of graphene sheets in multilayer graphene is preferably 2 to 10, more preferably 2 to 5.

A graphene sheet refers to a sheet composed of carbon atoms bonded to each other via sp² bonds in a planar arrangement and having a thickness corresponding to a single carbon atom. In a graphene sheet, carbon atoms are located at the respective vertices of the hexagonal lattice.

The method for producing graphene according to the present invention (hereinafter referred to as the "present production method") is carried out using a thermal CVD apparatus.

The thermal CVD apparatus includes: a gas supply unit connected to the reaction chamber to supply a source gas containing a hydrocarbon toward a substrate accommodated in the reaction chamber; and a gas exhaust unit connected to an opposite side of the reaction chamber from the gas supply unit to exhaust gas from inside the reaction chamber. The thermal CVD apparatus used in the present production method additionally includes a heater arranged to cover a region of the reaction chamber, including a region in which the substrate is accommodated, to heat the inside of the reaction chamber. The thermal CVD apparatus includes a cylindrical reaction chamber configured to accommodate therein a substrate for graphene production; and a gas supply unit connected to the reaction chamber to supply a source gas containing a hydrocarbon toward the substrate accommodated in the reaction chamber. The thermal CVD apparatus further includes: a gas exhaust unit connected to an opposite side of the reaction chamber from the gas supply unit to exhaust gas from inside the reaction chamber; a heater arranged to cover a region of the reaction chamber, including a region in which the substrate is accommodated, to heat the inside of the reaction chamber; and shielding members disposed in the reaction chamber to suppress heat transfer within the reaction chamber. The shielding members are arranged at least between the gas supply unit and the substrate and between the substrate and the gas exhaust unit.

The present production method satisfies a relationship of the following formula (x1): $W / S \leq 54.97 \times exp \left\{-0.128\times \left(x-4.0\right)\right\}$ (x1) where W is the flow rate of the source gas supplied from the gas supply unit; S is the internal cross-sectional area of the reaction chamber; and x is the internal diameter of the reaction chamber.

In the formula (x1), the unit of W is cm³/min, representing a gas flow rate per minute converted to a volume at 1 atm and 0°C.

In the formula (x1), the unit of S is cm².

In the formula (x1), the unit of x is cm.

While describing the thermal CVD apparatus used in the present production method in detail below, the present production method will also be described below. The present production method will be described in detail after describing the thermal CVD apparatus used in the present production method.

### <Thermal CVD Apparatus>

The thermal CVD apparatus used in the present production method includes a reaction chamber configured to accommodate therein a substrate for graphene production. The thermal CVD apparatus used in the present production method also includes: a gas supply unit connected to the reaction chamber to supply a source gas containing a hydrocarbon toward the substrate accommodated in the reaction chamber; and a gas exhaust unit connected to an opposite side of the reaction chamber from the gas supply unit to exhaust gas from inside the reaction chamber. In addition, the thermal CVD apparatus used in the present production method includes a heater arranged to cover a region of the reaction chamber, including a region in which the substrate is accommodated, to heat the inside of the reaction chamber.

Here, shielding members are disposed in the reaction chamber to suppress heat transfer within the reaction chamber. The shielding members are arranged at least between the gas supply unit and the substrate and between the substrate and the gas exhaust unit.

The thermal CVD apparatus used in the present production method will be described in detail below with reference to the drawings.

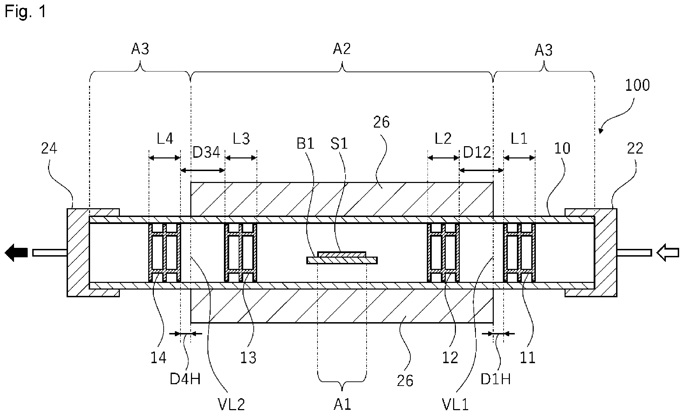

Fig. 1 is a schematic cross-sectional view of an embodiment of the thermal CVD apparatus used in the present production method.

A thermal CVD apparatus 100 includes a cylindrical reaction chamber 10. A substrate S1 for graphene production is accommodated in the reaction chamber 10 and is supported on a boat B1.

A gas supply unit 22 is connected to one end of the reaction chamber 10, whereas a gas exhaust unit 24 is connected to the other end of the reaction chamber 10. A source gas containing a hydrocarbon is supplied from the gas supply unit 22 toward the substrate S1 through a pipe (not shown) connected to the gas supply unit 22 (see white arrows in Fig. 1). The gas supplied from the gas supply unit 22 and consumed in the reaction inside the reaction chamber 10 is exhausted through the gas exhaust unit 24 (see black arrows in Fig. 1).

A heater 26 is arranged to cover a region A2 of the reaction chamber 10, including a region A1 in which the substrate S1 is accommodated, so that the inside of the reaction chamber 10 can be heated in the region A2 covered by the heater 26.

In the reaction chamber 10, a first shielding member 11, a second shielding member 12, a third shielding member 13, and a fourth shielding member 14 are arranged in this order from the gas supply unit 22 side.

The thermal CVD apparatus 100 produces graphene on the substrate S1 through thermal CVD by supplying the source gas from the gas supply unit 22 and heating the substrate S1 and the source gas with the heater 26.

In the thermal CVD apparatus 100, the second and third shielding members 12 and 13 are positioned in the region A2 of the reaction chamber 10 covered by the heater 26.

More specifically, the second shielding member 12 is located in the reaction chamber 10 at a position closer to the substrate S1 than a virtual line VL1, which represents a gas supply unit 22-side end of the heater 26 as shown in Fig. 1.

The third shielding member 13 is located in the reaction chamber 10 at a position closer to the substrate S1 than a virtual line VL2, which represents a gas exhaust unit 24-side end of the heater 26 as shown in Fig. 1.

In the thermal CVD apparatus 100, the first and fourth shielding members 11 and 14 are positioned in regions A3 of the reaction chamber 10 not covered by the heater 26.

More specifically, the first shielding member 11 is located in the reaction chamber 10 at a position closer to the gas supply unit 22 than the virtual line VL1, which represents one end of the heater 26 as shown in Fig. 1.

The fourth shielding member 14 is located in the reaction chamber 10 at a position closer to the gas exhaust unit 24 than the virtual line VL2, which represents the other end of the heater 26 as shown in Fig. 1.

Each of the first shielding member 11, the second shielding member 12, the third shielding member 13, and the fourth shielding member 14 has three shielding plates. The details of each shielding member will be described later.

In the embodiment shown in Fig. 1, the first, second, third, and fourth shielding plates 11, 12, 13, and 14 are used as the shielding members. In the present production method, however, for example, the second and third shielding members 12 and 13 may be omitted. In an alternative embodiment, the first and fourth shielding members 11 and 14 may be omitted.

The shielding members need to be arranged at least between the gas supply unit 22 and the substrate S1 and between the substrate S1 and the gas exhaust unit 24. The arrangement of the shielding members is not limited to that shown in Fig. 1.

By utilizing the thermal CVD apparatus 100 (the thermal CVD apparatus used in the present production method) and adjusting the conditions to satisfy the relationship of the formula (x1), uneven heating within the reaction chamber 10 can be suppressed.

The mechanism by which uneven heating within the reaction chamber 10 can be suppressed in the present production method is not necessarily clear, but is presumed as follows by the present inventors.

In the thermal CVD apparatus 100 shown in Fig. 1, the first, second, third, and fourth shielding members 11, 12, 13, and 14 are arranged at the above-described positions within the reaction chamber 10. In particular, the first and second shielding members 11 and 12 are arranged between the gas supply unit 22 and the substrate S1, and the third and fourth shielding members 13 and 14 are arranged between the substrate S1 and the gas exhaust unit 24. Each shielding member prevents heat from the heater 26 from transferring to the gas supply unit 22 side or the gas exhaust unit 24 side of the reaction chamber 10.

When the source gas is supplied from the gas supply unit 22 so as to satisfy the relationship of the formula (x1), the supply amount of the source gas becomes relatively small with respect to the internal diameter of the reaction chamber 10. As a result, the source gas supplied from the gas supply unit 22 is more likely to be sufficiently heated by the heater 26 and then fed toward the substrate S1. This allows the preheated source gas to be introduced into the region A1 in which the substrate S1 is accommodated, thereby suppressing uneven heating within the reaction chamber 10.

Descriptions will now be given of the details of the configuration of the thermal CVD apparatus 100, and of optional components that the thermal CVD apparatus 100 may include.

It should be understood that the thermal CVD apparatus used in the present production method is not limited to the embodiment shown in Fig. 1. Specifically, the respective components of the thermal CVD apparatus may be modified as described below.

The reaction chamber 10 has a cylindrical shape, and its internal diameter is, for example, 10 cm or larger, and is preferably 12.7 cm or larger, more preferably 15.24 cm or larger, still more preferably 20.32 cm or larger. The internal diameter is, for example, 50 cm or smaller, and is, from the viewpoint of more effectively suppressing uneven heating within the reaction chamber 10, preferably 38.1 cm or smaller, more preferably 35.56 cm or smaller, still more preferably 30.48 cm or smaller.

The wall thickness of the reaction chamber 10 is, for example, preferably 1 to 50 mm, more preferably 2 to 40 mm.

The length of the reaction chamber 10 is not particularly restricted, but is, for example, 20 m or shorter, preferably 10 m or shorter. The length of the reaction chamber 10 is, for example, 0.5 m or longer, and preferably 1 m or longer.

It is preferable that the reaction chamber 10 does not undergo deformation or other changes when heated by the heater 26.

Examples of the material constituting the reaction chamber 10 include those containing at least one selected from the group consisting of silicon oxide, silicon nitride, graphite, aluminum oxide, aluminum nitride, tantalum oxide, tantalum carbide, niobium oxide, niobium carbide, and molybdenum oxide.

In particular, silicon oxide (quartz glass) is preferred.

The gas supply unit 22 is not particularly restricted, as long as it is capable of supplying a source gas containing a hydrocarbon and controlling the supply amount of the source gas so as to satisfy the relationship of the formula (x1). For example, a flow control valve and a gas supply source are connected to the gas supply unit 22, so as to supply the source gas from the gas supply source while controlling the supply amount by means of the flow control valve.

The source gas supplied from the gas supply unit 22 may be a mixed gas as described later. In the case where a mixed gas is supplied as the source gas from the gas supply unit 22, a gas mixing unit may be provided. In the gas mixing unit, gases supplied from respective gas supply sources, which constitute the mixed gas, are mixed. In the case where a mixed gas is supplied as the source gas, it is preferable to provide flow control valves between the gas mixing unit and the gas supply sources.

The gas supply source may be, for example, a known gas cylinder.

The flow control valve may be, for example, a known mass flow controller.

The source gas will be described in detail later.

A pressure gauge may be connected to the gas supply unit 22. The supply amount of the source gas from the gas supply unit 22 may be controlled based on the pressure measured by the pressure gauge.

The pressure gauge may be a known pressure gauge selected according to a desired pressure range.

The gas exhaust unit 24 is not particularly restricted, as long as it is capable of exhausting gas from inside the reaction chamber 10. For example, the gas exhaust unit 24 connects the reaction chamber 10 to the outside via a valve (such as a check valve or a pressure control valve).

Furthermore, the gas exhaust unit 24 may be connected to a known exhaust gas treatment device. Examples of the exhaust gas treatment device include a combustion-type exhaust gas treatment device that burns hydrocarbons and other components contained in the exhaust gas.

A pressure gauge may be connected to the gas exhaust unit 24. The supply amount of the source gas from the gas supply unit 22 may be controlled based on the pressure measured by the pressure gauge. The opening of the pressure control valve may be adjusted based on the measured pressure.

The pressure gauge may be a known pressure gauge selected according to a desired pressure range.

A vacuum evacuation device may also be connected to the gas exhaust unit 24. The vacuum evacuation device connected to the gas exhaust unit 24 can be, for example, a known vacuum pump. In the case where a vacuum evacuation device is connected to the gas exhaust unit 24, the vacuum evacuation device may be connected to the gas exhaust unit 24 via the above valve and to the outside.

The heater 26 surrounds the region A2 of the reaction chamber 10, including the region A1 in which the substrate S1 is accommodated, and heats the inside of the reaction chamber 10. When the inside of the reaction chamber 10 is heated, both the substrate S1 accommodated in the reaction chamber 10 and the supplied source gas are heated, thereby forming graphene on the substrate S1.

The heater 26 is preferably capable of heating the inside of the reaction chamber 10 to 900°C or higher, more preferably 950°C or higher, still more preferably 1,000°C or higher.

The upper limit of the heating temperature is not particularly restricted, but is, for example, 1,200°C or lower.

The heater 26 is not particularly restricted, as long as it is capable of heating the inside of the reaction chamber 10. For example, the heater 26 may include a heat source and a heat-resistant plate disposed between the heat source and the reaction chamber 10. Examples of the heat source include those that generate heat by resistance heating. Examples of the heat-resistant plate include those made of fibers of aluminum oxide (such as alumina) or the like.

The first and second shielding members 11 and 12 prevent heat from the heater 26 from transferring to the gas supply unit 22 side of the reaction chamber 10. The third and fourth shielding members 13 and 14 prevent heat from the heater 26 from transferring to the gas exhaust unit 24 side of the reaction chamber 10.

The shielding members will now be described with the first shielding member 11 taken as a representative example.

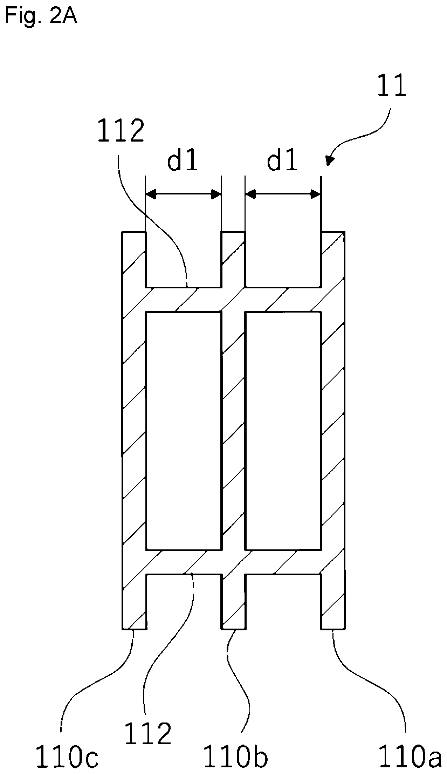

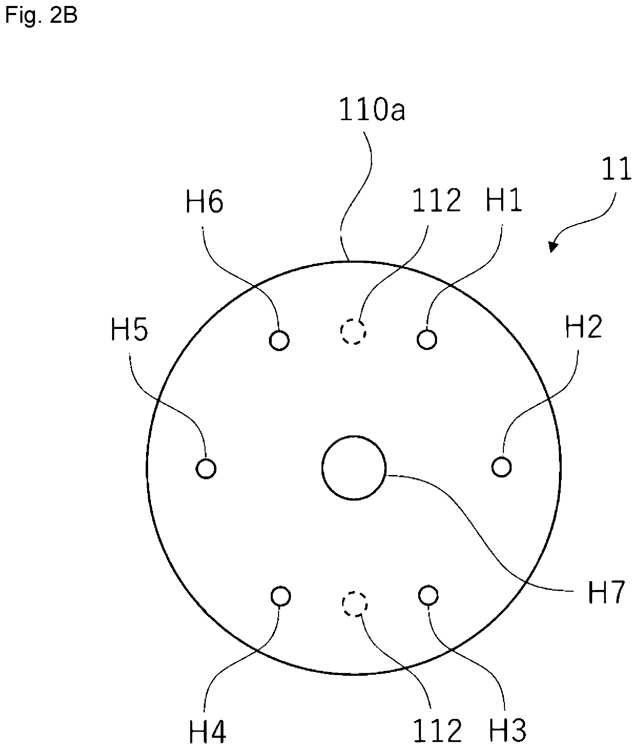

With reference to Figs. 2A and 2B, the details of the first shielding member 11 in the embodiment shown in Fig. 1 will be described below.

Fig. 2A is a schematic cross-sectional view of the first shielding member 11. As shown in Fig. 2A, the first shielding member 11 includes three shielding plates 110a, 110b and 110c. These three shielding plates 110a, 110b and 110c are coupled to one another by coupling rods 112, and are arranged at a constant interval d1.

Fig. 2B is a schematic view of the first shielding member 11 shown in Fig. 1, as viewed from the gas supply unit 22 side in the left-right direction in Fig. 1. In Fig. 2B, only the shielding plate 110a, which is positioned closest to the gas supply unit 22, is illustrated among the three shielding plates (110a, 110b and 110c) constituting the first shielding member 11.

As shown in Fig. 2B, the shielding plate 110a has seven holes H1 to H7. The holes H1 to H6 are provided at positions with six-fold symmetry with respect to the center of the circular shielding plate 110a, whereas the hole H7 is provided at the center of the circular shielding plate 110a.

The shielding plate 110a is preferably made of a material containing at least one selected from the group consisting of silicon oxide (such as quartz glass), silicon nitride, graphite, aluminum oxide, aluminum nitride, tantalum oxide, tantalum carbide, niobium oxide, niobium carbide, and molybdenum oxide. The shielding plate 110a may be made of metal. Examples of such metal include known metals such as iron, niobium, and molybdenum. The metal may be an alloy such as steel or stainless steel.

The thickness of the shielding plate 110a is not particularly restricted, but is often 0.1 mm or greater, preferably 0.5 mm or greater. The thickness of the shielding plate 110a is often 5.0 mm or smaller.

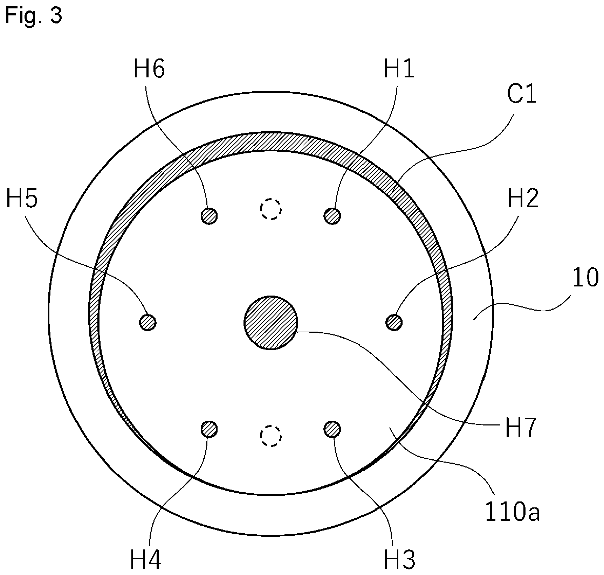

The size (e.g., diameter) of the shielding plate 110a is smaller than the internal cross-sectional size (e.g., diameter) of the reaction chamber 10, so that the shielding plate 110a can be installed in the reaction chamber 10. Accordingly, a clearance C1 is left between the shielding plate 110a and the inner wall of the reaction chamber 10 as shown in Fig. 3.

When the reaction chamber 10 has a cylindrical shape, the difference between the internal diameter of the reaction chamber 10 and the diameter of the shielding plate 110a is preferably 0.1 cm or more, more preferably 0.3 cm or more. The difference is preferably 3.0 cm or less.

The opening ratio of the shielding plate 110a relative to the internal cross-sectional area of the reaction chamber 10 is preferably 0.1% or greater, more preferably 1% or greater, still more preferably 5% or greater, particularly preferably 10% or greater. The opening ratio is preferably 65% or less, more preferably 32% or less, still more preferably 16% or less.

The opening ratio is defined as the ratio of the hatched area in Fig. 3 to the internal cross-sectional area of the reaction chamber 10. Fig. 3 is a schematic cross-sectional view of the reaction chamber 10 of the thermal CVD apparatus 100 shown in Fig. 1, taken at a portion corresponding to the shielding plate 110a of the first shielding member 11.

To obtain the opening ratio, first, the area of the shielding plate 110a excluding the portions of the holes (H1 to H7) is determined as the area of the shielding plate 110a. The determined area of the shielding plate 110a is then subtracted from the internal cross-sectional area of the reaction chamber 10. The resulting value is divided by the internal cross-sectional area of the reaction chamber 10 and multiplied by 100 to obtain the opening ratio (unit: %).

The opening ratio corresponds to the ratio of the area of a portion not blocked by the shielding plate 110a (a portion through which the source gas can pass) to the internal cross-sectional area of the reaction chamber 10.

The opening ratios of the shielding plates 110b and 110c are obtained in the same manner as described above.

The preferred ranges for the opening ratios of the shielding plates 110b and 110c are the same as those for the shielding plate 110a.

The opening ratio of the shielding plate 110a can be adjusted according to the number and size of the holes in the shielding plate 110a. For example, the opening ratio can be adjusted by varying the sizes of the holes H1 to H7 in the shielding plate 110a.

The configurations of the shielding plates 110b and 110c constituting the first shielding member 11 may be the same as or different from that of the shielding plate 110a.

For example, the opening ratios of the shielding plates 110a, 110b and 110c in the first shielding member 11 may be different from each other or may be the same.

It is also preferable that the first shielding member 11 includes shielding plates 110a, 110b, and 110c with different opening ratios. In the case where the first shielding member 11 includes shielding plates with different opening ratios, the opening ratio of the shielding plate closest to the gas supply unit 22 is preferably smaller than that of the shielding plate closest to the second shielding member 12. That is, in the case where the first shielding member 11 includes shielding plates with different opening ratios, the opening ratio of the shielding plate 110a is preferably smaller than that of the shielding plate 110c.

Furthermore, the product of the opening ratios of the shielding plates constituting the first shielding member 11 is preferably 0.0005% or greater, more preferably 0.0008% or greater, still more preferably 0.0010% or greater. The product of the opening ratios as described above is preferably 80.0000% or less, more preferably 10.0000% or less, still more preferably 6.0000% or less, particularly preferably 1.0000% or less.

The product of the opening ratios is obtained by multiplying the opening ratio of the shielding plate 110a, the opening ratio of the shielding plate 110b, and the opening ratio of the shielding plate 110c.

The configuration of the shielding plate 110a is not limited to that shown in Fig. 2B. For example, the arrangement, number, and size of the holes can be modified as needed.

The shielding plates 110b and 110c may have the same configuration as the shielding plate 110a. The shielding plates 110a, 110b, and 110c may be identical in configuration, partially similar in configuration, or different in configuration.

In the case where the first shielding member 11 includes three or more shielding plates, the intervals between adjacent shielding plates may be the same or different.

Although the first shielding member 11 includes three shielding plates in the embodiment of Fig. 1, the first shielding member 11 may alternatively include only a single shielding plate. In the case where the first shielding plate is composed of only a single shielding plate, the opening ratio of that shielding plate is regarded as the product of the opening ratios of the shielding plates. The first shielding member may include two or more shielding plates (for example, 2 to 10 plates, preferably 2 to 6 plates).

Examples of the configurations of the second, third, and fourth shielding members 12, 13 and 14 are the same as those of the first shielding member 11, and thus a description thereof will be omitted.

In particular, it is preferable that the opening ratio of the shielding plate in the first shielding member 11 is greater than the opening ratio of the shielding plate in the second shielding member 12, and that the opening ratio of the shielding plate in the fourth shielding member 14 is greater than the opening ratio of the shielding plate in the third shielding member 13. When the first shielding member 11 includes only one shielding plate, the opening ratio of the shielding plate in the first shielding member 11 refers to the opening ratio of that shielding plate. When the first shielding member 11 includes two or more shielding plates, the opening ratio of the shielding plate in the first shielding member 11 refers to the smallest opening ratio among the opening ratios of the shielding plates constituting the first shielding member 11.

The difference between the opening ratio of the shielding plate in the first shielding member 11 and the opening ratio of the shielding plate in the second shielding member 12 is preferably from 0 to 12.4%.

The difference between the opening ratio of the shielding plate in the fourth shielding member 14 and the opening ratio of the shielding plate in the third shielding member 13 is preferably from 0 to 12.4%.

From the viewpoint of more effectively suppressing uneven heating within the reaction chamber 10, it is also preferable that the difference between the opening ratio of the shielding plate in the first shielding member 11 and the opening ratio of the shielding plate in the second shielding member 12 is from 0 to 1%, and that the difference between the opening ratio of the shielding plate in the fourth shielding member 14 and the opening ratio of the shielding plate in the third shielding member 13 is from 0 to 1%.

Furthermore, it is preferable that the second shielding member 12 includes two or more shielding plates, and that the shielding plate of the second shielding member 12 located closest to the third shielding member 13 has a smaller opening ratio than that of the shielding plate of the second shielding member 12 located closest to the first shielding member 11.

It is also preferable that the third shielding member 13 includes two or more shielding plates, and that the shielding plate of the third shielding member 13 located closest to the second shielding member 12 has a smaller opening ratio than that of the shielding plate of the third shielding member 13 located closest to the fourth shielding member 14.

The difference between the opening ratio of the shielding plate of the second shielding member 12 located closest to the third shielding member 13 and the opening ratio of the shielding plate of the second shielding member 12 located closest to the first shielding member 11 is preferably from 0 to 12.4%.

The difference between the opening ratio of the shielding plate of the third shielding member 13 located closest to the second shielding member 12 and the opening ratio of the shielding plate of the third shielding member 13 located closest to the fourth shielding member 14 is preferably from 0 to 12.4%.

Moreover, it is preferable that the fourth shielding member 14 includes two or more shielding plates, and that the shielding plate of the fourth shielding member 14 located closest to the gas exhaust unit 24 has a smaller opening ratio than that of the shielding plate of the fourth shielding member 14 located closest to the third shielding member 13.

The difference between the opening ratio of the shielding plate of the fourth shielding member 14 located closest to the gas exhaust unit 24 and the opening ratio of the shielding plate of the fourth shielding member 14 located closest to the third shielding member 13 is preferably from 0 to 12.4%.

A value obtained by multiplying the product of the opening ratios of the shielding plates constituting the first shielding member 11 by the product of the opening ratios of the shielding plates constituting the second shielding member 12 is preferably 0.0004% or greater, more preferably 0.0006% or greater, still more preferably 0.0008% or greater, particularly preferably 0.0010% or greater. The value obtained by multiplying the products of the opening ratios as described above is preferably 0.0700% or less, more preferably 0.0100% or less, still more preferably 0.0020% or less.

Furthermore, a value obtained by multiplying the product of the opening ratios of the shielding plates constituting the third shielding member 13 by the product of the opening ratios of the shielding plates constituting the fourth shielding member 14, is preferably 0.0004% or greater, more preferably 0.0006% or greater, still more preferably 0.0008% or greater, particularly preferably 0.0010% or greater. The value obtained by multiplying the products of the opening ratios as described above is preferably 0.0700% or less, more preferably 0.0100% or less, still more preferably 0.0020% or less.

In Fig. 1, the distance between the first and second shielding members 11 and 12 is denoted as D12, and the distance between the third and fourth shielding members 13 and 14 is denoted as D34.

The distance D12 refers to a distance from an end of the first shielding member 11 closest to the second shielding member 12 to an end of the second shielding member 12 closest to the first shielding member 11. Similarly, the distance D34 refers to a distance from an end of the third shielding member 13 closest to the fourth shielding member 14 to an end of the fourth shielding member 14 closest to the third shielding member 13.

The case is now considered where each of the first, second, third, and fourth shielding members 11, 12, 13, and 14 includes two or more shielding plates arranged at a constant interval d1 (see Fig. 2A).

In this case, the ratio of the distance D12 to the interval d1, denoted as D12/d1, is preferably 0.03 or greater, more preferably 1.2 or greater, still more preferably 2.7 or greater, from the viewpoint of allowing the source gas to remain longer between the first and second shielding members 11 and 12 for preheating, thereby more effectively suppressing uneven heating within the reaction chamber 10. The ratio D12/d1 is preferably 52.88 or less, more preferably 23.50 or less, still more preferably 3.8 or less, from the viewpoint of allowing the source gas to remain longer between the shielding plates, thereby more effectively suppressing uneven heating within the reaction chamber 10.

The ratio of the distance D34 to the interval d1, denoted as D34/d1, is also preferably 0.03 or greater, more preferably 1.2 or greater, still more preferably 2.7 or greater, from the viewpoint of allowing gas to remain longer between the third and fourth shielding members 11 and 12 for heating, thereby more effectively suppressing uneven heating within the reaction chamber 10. The ratio D34/d1 is preferably 52.88 or less, more preferably 23.50 or less, still more preferably 3.8 or less, from the viewpoint of allowing the gas to remain longer between the shielding plates for heating, thereby more effectively suppressing uneven heating within the reaction chamber 10.

Further, in Fig. 1, the length of the first shielding member 11 is denoted as L1, the length of the second shielding member 12 is denoted as L2, the length of the third shielding member 13 is denoted as L3, and the length of the fourth shielding member 14 is denoted as L4. The length of each shielding member refers to a length from one end to the other end of the shielding member.

The ratio of the distance D12 to the length L1, denoted as D12/L1, and the ratio of the distance D12 to the length L2, denoted as D12/L2, are each preferably 0.01 or greater, more preferably 0.43 or greater, still more preferably 1.00 or greater. The above ratios (the ratio D12/L1 and the ratio D12/L2) are each preferably 23.27 or less, more preferably 10.34 or less, still more preferably 1.39 or less.

The ratio of the distance D34 to the length L3, denoted as D34/L3, and the ratio of the distance D34 to the length L4, denoted as D34/L4, are each preferably 0.01 or greater, more preferably 0.43 or greater, still more preferably 1.00 or greater. The above ratios (D34/L3 and D34/L4) are each preferably 23.27 or less, more preferably 10.34 or less, still more preferably 1.39 or less.

Moreover, in Fig. 1, the distance from the gas supply unit 22-side end of the region A2 of the reaction chamber 10 covered by the heater 26 (virtual line VL1) to the first shielding member 11 is denoted as D1H, and the distance from the gas exhaust unit 24-side end of the region A2 of the reaction chamber 10 covered by the heater 26 (virtual line VL2) to the fourth shielding member 14 is denoted as D4H.

In this case, the value of X1H calculated by the following formula (1) is preferably 0.01 or greater.

Similarly, the value of X4H calculated by the following formula (2) is preferably 0.01 or greater.

When the values of the X1H and X4H are within the above ranges, uneven heating within the reaction chamber 10 can be more effectively suppressed. $X 1 H = \left(D12-D1H\right) / D 12$ (1) $X 4 H = \left(D34-D4H\right) / D 34$ (2)

The value of X1H represents the ratio of the length of a portion of the distance D12 not covered by the heater 26 to the total distance D12. Similarly, the value of X4H represents the ratio of the length of a portion of the distance D34 not covered by the heater 26 to the total distance D34.

When the value of X1H is 1.00, it indicates that the gas supply unit 22-side end of the heater 26 aligns with the end of the first shielding member 11 closer to the second shielding member 12.

Similarly, when the value of X4H is 1.00, it indicates that the gas exhaust unit 24-side end of the heater 26 aligns with the end of the fourth shielding member 14 closer to the third shielding member 13.

From the viewpoint of more effectively suppressing uneven heating within the reaction chamber 10, the value of X1H is preferably 0.60 or greater, more preferably 0.80 or greater.

From the viewpoint of more effectively suppressing uneven heating within the reaction chamber 10, the value of X4H is preferably 0.60 or greater, more preferably 0.80 or greater.

The maximum values of X1H and X4H are both 1.00.

In the case where the second and third shielding members 12 and 13 are omitted, the distances D1H and D4H are each preferably 50 cm or shorter, more preferably 15 cm or shorter. The distances D1H and D4H may be each 0 cm.

In the case where the second and third shielding members 12 and 13 are omitted, the first shielding member 11 is preferably positioned closer to the gas supply unit 22 than the virtual line VL1. In the case where the second and third shielding members 12 and 13 are omitted, the fourth shielding member 14 is preferably positioned closer to the gas exhaust unit 24 than the virtual line VL2.

In the case where the second and third shielding members 12 and 13 are omitted, the product of the opening ratios of the shielding plates constituting the first shielding member 11 is preferably 0.0004% or greater, more preferably 0.0006% or greater, still more preferably 0.0008% or greater, particularly preferably 0.0010% or greater. The product of the opening ratios as described above is preferably 0.0700% or less, more preferably 0.0100% or less, still more preferably 0.0020% or less.

In the case where the second and third shielding members 12 and 13 are omitted, the product of the opening ratios of the shielding plates constituting the fourth shielding member 14 is preferably 0.0004% or greater, more preferably 0.0006% or greater, still more preferably 0.0008% or greater, particularly preferably 0.0010% or greater. The product of the opening ratios as described above is preferably 0.0700% or less, more preferably 0.0100% or less, still more preferably 0.0020% or less.

The boat B1 is provided to hold thereon the substrate S1. In general, the boat B1 is transported into the reaction chamber 10 with the substrate S1 placed on the boat B1.

A top surface of the boat B1, on which the substrate S1 is placed, may be flat or may have rails, claws or other members for fixing the substrate S1.

It is preferable that the boat B1 does not deform when heated by the heater 26.

### Examples of the material constituting the boat B1 include the same materials as those used for the shielding plates.

In the embodiment shown in Fig. 1, the boat B1 is configured to hold one substrate S1. Alternatively, the boat B1 may be configured to hold two or more substrates S1. In such a case, the substrates S1 may be arranged on the boat B1 in the left-right direction in Fig. 1, or in the front-back direction or up-down direction in Fig. 1. Among these, it is preferable to arrange the substrates S1 in the up-down direction Fig. 1 from the viewpoint of facilitating uniform supply of the source gas.

In the production of graphene on the substrate S1 using the thermal CVD apparatus, the boat B1 may be omitted if unnecessary. The boat B1 may be replaced with a holder or the like capable of supporting the substrate S1.

### <Method for Producing Graphene>

The method for producing graphene according to the present invention (referred to as the present production method) is carried out using the above-described CVD apparatus (for example, the thermal CVD apparatus 100 shown in Fig. 1).

More specifically, a source gas containing a hydrocarbon is supplied from the gas supply unit 22 to a substrate S1 accommodated in the reaction chamber 10, and the source gas and the substrate S1 in the reaction chamber 10 are heated by the heater 26 to form graphene on the substrate S1.

As described above, in the present production method, a thermal CVD apparatus other than that shown in Fig. 1 may be used.

The supply amount of the source gas is controlled so as to satisfy the relationship of the formula (x1).

The substrate S1 preferably has a metal film. The metal film is preferably provided on a surface of the substrate S1.

The metal film preferably contains at least one metal selected from the group consisting of copper, nickel, and iron, more preferably contains copper or nickel, and still more preferably contains copper. The metal film may be made of the above metal in elemental form or may be made of an alloy containing the above metal.

It is preferable that a surface of the metal surface whose lattice constant matches that of graphene is exposed. More specifically, the copper (111) plane or the nickel (111) plane is preferably exposed. It is more preferable that only the surface having the above Miller index is exposed on the metal film.

The substrate S1 preferably has an oxide layer as a base layer for the above metal film.

The oxide layer preferably has a lattice constant that matches that of the above metal film. As such an oxide layer, an oxide film containing at least one element selected from the group consisting of magnesium, aluminum, titanium, and lanthanum is preferably used. An oxide film containing magnesium or aluminum is more preferably used. Preferred examples of the oxide film include films of MgO (magnesium oxide), α-Al₂O₃ (alumina), LaAlO₃, and TiO_{2.} A film of MgO or α-Al₂O₃ is particularly preferred.

As an example of the substrate S1 with an oxide layer and a metal film, an embodiment may be mentioned in which the metal film is formed on a substrate body made of the material of the oxide layer.

As another example of the substrate S1 with an oxide layer and a metal film, an embodiment may be mentioned in which the oxide layer and the metal film are formed on a substrate body in this order. Examples of the material for the substrate body include those containing SiO₂ (quartz). It is also preferable that the substrate body has a low linear thermal expansion coefficient.

The source gas contains a hydrocarbon. In addition to the hydrocarbon, the source gas may contain at least one of an inert gas and a reducing gas.

Examples of the hydrocarbon include methane, ethane, ethylene, acetylene, propane, propylene, butane, butadiene, pentane, pentene, cyclopentadiene, hexane, cyclohexane, benzene, and toluene. These hydrocarbons may be used solely or in combination of two or more thereof.

Examples of the inert gas include nitrogen gas, helium gas, neon gas, argon gas, and krypton gas. These inert gases may be used solely or in combination of two or more thereof.

Examples of the reducing gas include hydrogen gas.

The case is now considered where the source gas contains a hydrocarbon, an inert gas, and a reducing gas.

In this case, the content of the hydrocarbon relative to the total volume of the source gas is preferably 0.00001 vol% or more, more preferably 0.0001 vol% or more. The content of the hydrocarbon is preferably 0.1 vol% or less, more preferably 0.01 vol% or less.

Further, the content of the inert gas relative to the total volume of the source gas is preferably 90 vol% or more, more preferably 95 vol% or more, still more preferably 98 vol% or more. The content of the inert gas is often 99.9 vol% or less.

The content of the reducing gas relative to the total volume of the source gas is preferably 0.01 vol% or more, more preferably 0.1 vol% or more. The content of the reducing gas is preferably 5 vol% or less, more preferably 2 vol% or less.

The supply amount of the source gas is controlled so as to satisfy the relationship of the formula (x1) as described above.

More specifically, the supply amount of the source gas satisfies the relationship of the formula (x1): $W / S \leq 54.97 \times exp \left\{-0.128\times \left(x-4.0\right)\right\}$ (x1) where W is the flow rate of the source gas introduced from the gas supply unit 22; S is the internal cross-sectional area of the reaction chamber 10; and x is the internal diameter of the reaction chamber 10.

In the formula (x1), the unit of W is cm³/min, representing a gas flow rate per minute converted to a volume at 1 atm and 0°C.

In the formula (x1), the unit of S is cm².

In the formula (x1), the unit of x is cm.

A value obtained by dividing the left-hand side by the right-hand side of the formula (x1) is preferably 0.01 or greater, more preferably 0.1 or greater, still more preferably 0.3 or greater, particularly preferably 0.5 or greater. The above value is preferably 1 or less, more preferably 0.97 or less.

The heating temperature inside the reaction chamber 10 by the heater 26 is preferably 900°C or higher, more preferably 950°C or higher, still more preferably 1,000°C or higher. The heating temperature inside the reaction chamber 10 by the heater 26 is preferably 1,200°C or lower, more preferably 1,150°C or lower, still more preferably 1,100°C or lower.

The heating temperature inside the reaction chamber 10 can be measured, for example, by a thermocouple inserted therein along with the boat B1 and the substrate S1.

The heating time inside the reaction chamber 10 by the heater 26 is preferably 5 minutes or longer, more preferably 10 minutes or longer. The heating time is preferably 120 minutes or shorter, more preferably 60 minutes or shorter.

The heating inside the reaction chamber 10 by the heater 26 may be carried out by dividing the chamber into a plurality of zones and controlling the heating temperature of each zone independently.

In the embodiment shown in Fig. 1, for example, the region A2 may be divided into a zone A2a from the virtual line VL1 to the substrate S1-side end of the second shielding member 12, a zone A2b from the substrate S1-side end of the second shielding member 12 to the substrate S1-side end of the third shielding member 13, and a zone A2c from the substrate S1-side end of the third shielding member 13 to the virtual line VL2.

When the region A2 is divided into zones A2a, A2b, and A2c as described above, these zones A2a, A2b, and A2c may be controlled at different temperatures. For example, the zone A2b is preferably controlled within the temperature range described above for the heating temperature inside the reaction chamber 10 by the heater 26, and the heating temperatures in the zones A2a and A2c are preferably controlled to be 180 to 280°C (more preferably 200 to 260°C) higher than the heating temperature in the zone A2b.

A value obtained by dividing the temperature (°C) measured at the following first position by the temperature (°C) measured at the following second position is preferably 0.62 or greater.

First position: a position in the axial direction of the reaction chamber 10 corresponding to the substrate S1-side surface of the first shielding member 11.

Second position: a position in the axial direction of the reaction chamber 10 corresponding to the center of the substrate S1.

The axial direction of the reaction chamber 10 refers to the longitudinal direction of the reaction chamber 10 (the left-right direction in Fig. 1).

As a method for measuring the temperatures at the first and second positions, for example, a known thermocouple may be placed at each position to measure the temperature.

The above value is more preferably 0.9 or greater. Further, the above value is often 1.0 or less.

As a method for adjusting the temperature difference, for example, the region A2 may be divided into zones A2a, A2b, and A2c, with each zone controlled independently. The preferred temperatures are as described above.

Furthermore, a value obtained by dividing the temperature (°C) measured at the following third position by the temperature (°C) measured at the above second position is preferably 0.62 or greater.

Third position: a position in the axial direction of the reaction chamber 10 corresponding to the substrate S1-side surface of the fourth shielding member 14.

A method for measuring the temperature at the third position may be the same as the method for measuring the temperatures at the first and second positions.

The above value is more preferably 0.9 or greater. Further, the above value is often 1.0 or less.

As a method for adjusting the temperature difference, for example, the region A2 may be divided into zones A2a, A2b, and A2c, with each zone controlled independently. The preferred temperatures are as described above.

After forming graphene on the substrate S1 by the above-described procedure, the inside of the reaction chamber 10 may be cooled.

During the cooling of the inside of the reaction chamber 10, a gas supplied from the gas supply unit 22 may contain a hydrocarbon or may be free of hydrocarbons.

The cooling may be carried out by removing the heater 26 from the reaction chamber 10 and then cooling the reaction chamber 10 in air, or by cooling the chamber in a furnace with the heater 26 still attached to the reaction chamber 10.

The method for producing graphene according to the present invention is carried out utilizing the above-described thermal CVD apparatus 100 usable in the present production method and includes the steps of: supplying a source gas containing a hydrocarbon from the gas supply unit 22 to the substrate S1 accommodated in the reaction chamber 10; and heating the source gas and the substrate S1 in the reaction chamber 10 by the heater 26, thereby forming graphene on the substrate S1. The method may further include any other step.

An example of such other step is a step of arranging the first, second, third, and fourth shielding members 11, 12, 13, and 14, the boat B1 and the substrate S1 within the reaction chamber 10 before the formation of graphene.

Another example of such other step is a step of, before the formation of graphene, supplying a gas containing a reducing gas and free of hydrocarbons from the gas supply unit 22 to the substrate S1 accommodated in the reaction chamber 10, and heating the inside of the reaction chamber 10 with the heater 26. By this step, the surface of the substrate S1 is reduced, facilitating the formation of graphene.

The gas supplied in the above step may also preferably contain an inert gas of the type described above in addition to the reducing gas.

The heating by the heater 26 in the above step can be appropriately adjusted depending on the material contained in the substrate S1. The heating temperature is, for example, 300 to 1,200°C, and is preferably 500 to 1,100°C.

When performing the above step, it is preferable to first supply the gas containing the reducing gas from the gas supply unit 22, then supply only the inert gas from the gas supply unit 22 to purge the reaction chamber 10 with the inert gas, and thereafter supply the source gas containing the hydrocarbon to start the formation of graphene.

### <Applications>

Graphene formed on the substrate S1 can be utilized for various applications.

For example, graphene can be used in electromagnetic wave detection elements, electromagnetic wave sensors, electronic devices, and structural components. In particular, a laminate including single-layer graphene with excellent SPP propagation characteristics can be suitably used as a broadband electromagnetic wave detection element, an amplification element, or an oscillation element.

The above-mentioned elements can each be manufactured by a known method using graphene formed on the substrate S1. For example, the formed graphene can be processed into a desired shape by photolithography and electron beam lithography.

Further, the formed graphene can be used in devices by connecting desired electrodes or the like through a known semiconductor manufacturing process.

### EXAMPLES

Now, the present invention will be described in further detail with reference to the following Examples.

The materials, amounts, proportions, processing details, and procedures shown in the following Examples can be appropriately modified without departing from the scope of the present invention. Therefore, it should be understood that the scope of the present invention is by no means limited to the following Examples.

Here, Ex. 1 to 4 correspond to Examples of the present invention; and Ex. 5 to 8 correspond to Comparative Examples.

### <Ex. 1>

Into the reaction chamber 10 made of quartz glass with a length of 170 cm and an internal diameter of 14 cm, the fourth shielding member 14, the third shielding member 13, the boat B1 with a substrate S1, the second shielding member 12, and the first shielding member 11 were inserted in this order. The arrangement was adjusted such that the center of the substrate S1 coincided with the axial center of the reaction chamber 10.

Subsequently, the gas supply unit 22 and the gas exhaust unit 24 were connected to both ends of the reaction chamber 10. A gas mixing unit (not shown) was connected to the gas supply unit 22. An argon gas cylinder as an argon gas supply source, a hydrogen gas cylinder as a hydrogen gas supply source, and a methane gas cylinder as a hydrocarbon supply source were connected to the gas mixing unit via respective mass flow controllers (none of which are shown).

The heater 26 was then arranged around the reaction chamber 10 to cover a region A2 of the chamber, including a region A1 in which the substrate S1 was accommodated. More specifically, the heater 26 was arranged to cover a 52.5 cm region on both sides from the axial center of the reaction chamber 10.

Each of the first, second, third, and fourth shielding members 11, 12, 13, and 14 was composed of three shielding plates, and the opening ratio of each of the shielding plates was 16%.

The arrangement of the respective shielding members was adjusted to positions corresponding to calculated values shown in Table 1 below.

Thermocouples (not shown) were inserted into the reaction chamber 10 to monitor the temperature of the inner wall of the reaction chamber 10 at each position. More specifically, the thermocouples were positioned such that the sensing portions of the thermocouples were located at the center of the substrate S1 and at positions 35 cm on both sides from the center of the substrate S1 in the axial direction of the reaction chamber 10.

In other words, with the center of the substrate S1 as the origin, the thermocouples were arranged at positions of -35 cm, 0 cm, and 35 cm in the axial direction of the reaction chamber 10.

To calculate uneven heating within the reaction chamber 10 by thermal fluid simulation, a model was created in which each component was arranged in the reaction chamber 10. In this model, argon gas was supplied at a flow rate shown in the table below, and the output of the heater 26 was adjusted such that the surface temperature of the heater 26 reached 1,050°C. The simulation was performed until a steady state was achieved.

The maximum temperature difference in the temperature distribution at the steady state was taken as a measure of uneven heating. Here, the temperature distribution was analyzed along a plane parallel to the axial direction of the reaction chamber 10 and perpendicular to the surface of the substrate S1.

### <Ex. 2 to 8>

The measure of uneven heating within the reaction chamber 10 was obtained in the same manner as in Ex. 1, except that each shielding member and its conditions were adjusted so as to satisfy the conditions shown in the table below.

For example, in Ex. 2, the second and third shielding members 12 and 13 were omitted.

### <Results>

Table 1 shows, for each Ex, the shielding members and their conditions, as well as the measure of uneven heating.

In Table 1, the opening ratio refers to the opening ratio of each shielding plate in each shielding member.

In Table 1, the maximum temperature difference refers to a value calculated by the method described above.

In Table 1, the values of D12/L1, D12/L2, D34/L3, D34/L4, X1H, and X4H are values determined by the methods described above.

| Table 1 | | Ex. 1 | Ex. 2 | Ex. 3 | Ex. 4 | Ex. 5 | Ex. 6 | Ex. 7 | Ex. 8 |
|---|---|---|---|---|---|---|---|---|---|
| First Shielding Member | Opening Ratio [%] | 16.0 | 16.0 | 16.0 | 16.0 | 16.0 | 16.0 | 16.0 | 16.0 |
| D12/L1 | | 1.0 | - | 1.0 | - | 1.0 | - | 1.0 | - |
| Second Shielding Member | Opening Ratio [%] | 16.0 | - | 16.0 | - | 16.0 | - | 16.0 | - |
| D 12/L2 | | 1.0 | - | 1.0 | - | 1.0 | - | 1.0 | - |
| Third Shielding Member | Opening Ratio [%] | 16.0 | - | 16.0 | - | 16.0 | - | 16.0 | - |
| D34/L3 | | 1.0 | - | 1.0 | - | 1.0 | - | 1.0 | - |
| Fourth Shielding Member | Opening Ratio [%] | 16.0 | 16.0 | 16.0 | 16.0 | 16.0 | 16.0 | 16.0 | 16.0 |
| D34/L4 | | 1.0 | - | 1.0 | - | 1.0 | - | 1.0 | - |
| X1H | | 1.0 | - | 1.0 | - | 1.0 | - | 1.0 | - |
| X4H | | 1.0 | - | 1.0 | - | 1.0 | - | 1.0 | - |
| Reaction Chamber | Internal Diameter [cm] | 14 | 14 | 28 | 28 | 14 | 14 | 28 | 28 |
| Gas Supply Amount [sccm] | | 1500 | 1500 | 1500 | 1500 | 15000 | 15000 | 15000 | 15000 |
| (Right-Hand Side) - (Left-Hand Side) of Formula (x1) | | 5.54 | 5.54 | 0.11 | 0.11 | -82.16 | -82.16 | -21.81 | -21.81 |
| (Left-Hand Side) / (Right-Hand Side) of Formula (x1) | | 0.64 | 0.64 | 0.96 | 0.96 | 6.38 | 6.38 | 9.57 | 9.57 |
| Maximum Temperature Difference [°C] | | 1.0 | 4.6 | 1.2 | 9.2 | 59.0 | 165.8 | 11.2 | 68.6 |

From the results shown in Table 1, and more specifically from the comparison between Ex. 1 to 4 and Ex. 5 to 6, it was confirmed that uneven heating within the reaction chamber 10 was suppressed when the relationship of the formula (x1) was satisfied (i.e., the value in the "(Right-Hand Side) - (Left-Hand Side) of Formula (x1)" column in Table 1 was positive).

From the comparison of Ex. 1 and 3 with Ex. 2 and 4, it was confirmed that uneven heating within the reaction chamber 10 was further suppressed when the first, second, third, and fourth shielding members were arranged, as the shielding members, in this order from the gas-supply-unit side to the gas-exhaust-unit side of the reaction chamber, with the second and third shielding members being positioned in the region of the reaction chamber covered by the heater and the first and fourth shielding members being positioned in the regions of the reaction chamber not covered by the heater.

### <Formation of Graphene>

Using a rolled copper foil (manufactured by JX Advanced Metal Corporation) as the substrate S1, graphene was formed on the substrate S1.

More specifically, under the conditions of Ex. 2, a mixed gas of argon and hydrogen gases (argon gas: 96.4 vol%, hydrogen gas: 3.6 vol%) was supplied at 500 sccm from the gas supply unit 22, and the heater 26 was heated so that the temperature measured by the thermocouple inserted at the center of the substrate S1 reached 1050°C. After reaching 1050°C, the temperature measured by the thermocouple was maintained at 1050°C for 40 minutes.

Next, the supplied gas was switched to a source gas containing a hydrocarbon. The source gas contained 0.000658 vol% methane gas, 0.911392 vol% hydrogen gas, and 99.087950 vol% argon gas. The temperature measured by the thermocouple was maintained at 1050°C for 41 minutes after the supplied gas was switched to the source gas.

Thereafter, the supplied gas was switched to pure argon gas. The output of the heater 26 was set to 0 W, and the inside of the reaction chamber 10 was cooled.

After the cooling, the substrate S1 was removed from the reaction chamber 10.

When the surface of the substrate S1 obtained by the above procedure was examined, a film was found to be deposited on the surface. By Raman spectroscopy analysis of the film, the presence of a single-layer graphene sheet was confirmed. It was further confirmed by optical microscopic observation that 35.8 % of the surface area of the substrate S1 was covered with graphene.

The entire disclosure of Japanese Patent Application No. 2023-220821 filed on December 27, 2023, including specification, claims, drawings and summary, is incorporated herein by reference in its entirety.

### REFERENCE SYMBOLS

10: Reaction chamber
11: First shielding member
12: Second shielding member
13: Third shielding member
14: Fourth shielding member
22: Gas supply unit
24: Gas exhaust unit
26: Heater
100: Thermal CVD apparatus
110a, 110b, 110c: Shielding plate

## Claims

1. A method for producing graphene using a thermal CVD apparatus,
the thermal CVD apparatus comprising:
a cylindrical reaction chamber configure to accommodate therein a substrate for graphene production;
a gas supply unit connected to the reaction chamber to supply a source gas containing a hydrocarbon toward the substrate accommodated in the reaction chamber;
a gas exhaust unit connected to an opposite side of the reaction chamber from the gas supply unit to exhaust gas from inside the reaction chamber;
a heater arranged to cover a region of the reaction chamber, including a region in which the substrate is accommodated, to heat the inside of the reaction chamber; and
shielding members disposed in the reaction chamber to suppress heat transfer within the reaction chamber,
the shielding member being arranged at least between the gas supply unit and the substrate and between the substrate and the gas exhaust unit, and
the method satisfying a relationship of the following formula (x1):$W / S \leq 54.97 \times exp \left\{-0.128\times \left(x-4.0\right)\right\}$ (x1) where W is a flow rate of the raw material gas introduced from the gas supply unit; S is an internal cross-sectional area of the reaction chamber; and x is an internal diameter of the reaction chamber;
W is in units of cm³/min, representing a gas flow rate per minute converted to a volume at 1 atm and 0°C;
S is in units of cm²; and
x is in units of cm.

2. The method for producing graphene according to Claim 1, wherein:
the shielding members include first, second, third, and fourth shielding members arranged inside the reaction chamber in order from a gas-supply-unit side to a gas-exhaust-unit side of the reaction chamber; and
the second and third shielding members are positioned in the region of the reaction chamber covered by the heater; and
the first and fourth shielding members are positioned in regions of the reaction chambers not covered by the heater.

3. The method for producing graphene according to Claim 2, wherein:
each of the first, second, third, and fourth shielding members comprises either one shielding plate or two or more shielding plates;
each shielding plate has one or more holes; and
an opening ratio of each shielding plate relative to the internal cross-sectional area of the reaction chamber is 0.1 to 40%.

4. The method for producing graphene according to Claim 3, wherein:
each of the first, second, third, and fourth shielding members comprises two or more shielding plates arranged at a constant interval d1; and
a ratio D12/d1 of a distance D12 between the first and second shielding members to the interval d1, and a ratio D34/d1 of a distance D34 between the third and fourth shielding members to the interval d1, are each 0.03 to 52.88.

5. The method for producing graphene according to Claim 4, wherein:
a ratio D12/L1 of the distance D12 between the first and second shielding members to L1, and a ratio D12/L2 of the distance D12 between the first and second shielding members to L2, are each 0.01 to 23.27; and
a ratio D34/L3 of the distance D34 between the third and fourth shielding members to L3, and a ratio D34/L4 of the distance D34 between the third and fourth shielding members to L4, are each 0.01 to 23.27,
where L1 is a length of the first shielding member;
L2 is a length of the second shielding member;
L3 is a length of the third shielding member; and
L4 is a length of the fourth shielding member.

6. The method for producing graphene according to Claim 4 or 5, wherein:
a value of X1H calculated by the following formula (1) using the distance D12 is 0.01 or greater; and
a value of X4H calculated by the following formula (2) using the distance D34 is 0.01 or greater: $X 1 H = \left(D12-D1H\right) / D 12$ (1) $X 4 H = \left(D34-D4H\right) / D 34$ (2) where D1H is a distance from a gas-supply-unit-side end of the region covered by the heater to the first shielding member; and
D4H is a distance from a gas-exhaust-unit-side end of the region covered by the heater to the fourth shielding member.

7. The method for producing graphene according to Claim 6, wherein the values of X1H and X4H are each 0.60 to 1.00.

8. The method for producing graphene according to any one of Claims 3 to 5, wherein:
the opening ratio of the shielding plate in the first shielding member is greater than the opening ratio of the shielding plate in the second shielding member; and
the opening ratio of the shielding plate in the fourth shielding member is greater than the opening ratio of the shielding plate in the third shielding member.

9. The method for producing graphene according to any one of Claims 3 to 5, wherein a product of the opening ratios of the shielding plates that constitute the first and second shielding members, respectively, and a product of the opening ratios of the shielding plates that constitute the third and fourth shielding members, respectively, are each 0.0009 to 0.0700%.

10. The method for producing graphene according to any one of Claims 3 to 5, wherein:
the second shielding member comprises two or more shielding plates, including shielding plates with different opening ratios; and
the third shielding member comprises two or more shielding plates, including shielding plates with different opening ratios.

11. The method for producing graphene according to any one of Claims 3 to 5, wherein:
the second shielding member comprises two or more shielding plates, and the shielding plate of the second shielding member located closest to the third shielding member has an opening ratio smaller than that of the shielding plate of the second shielding member located closest to the first shielding member; and
the third shielding member comprises two or more shielding plates, and the shielding plate of the third shielding member located closest to the second shielding member has an opening ratio smaller than that of the shielding plate of the third shielding member located closest to the fourth shielding member.

12. The method for producing graphene according to any one of Claims 3 to 5, wherein:
the first shielding member comprises two or more shielding plates, and the shielding plate of the first shielding member located closest to the gas supply unit has an opening ratio smaller than that of the shielding plate of the first shielding member located closest to the second shielding member; and
the fourth shielding member comprises two or more shielding plates, and the shielding plate of the fourth shielding member located closest to the gas exhaust unit has an opening ratio smaller than that of the shielding plate of the fourth shielding member located closest to the third shielding member.

13. The method for producing graphene according to any one of Claims 3 to 5, wherein the shielding plate comprises at least one selected from the group consisting of silicon oxide, silicon nitride, graphite, aluminum oxide, aluminum nitride, tantalum oxide, tantalum carbide, niobium oxide, niobium carbide, and molybdenum oxide.

14. The method for producing graphene according to any one of Claims 3 to 5, wherein the second and third shielding members are made of metal.

15. The method for producing graphene according to any one of Claims 1 to 5, wherein a value obtained by dividing a temperature measured at the following first position by a temperature measured at the following second position is 0.62 or greater,
provided that:
the first position is a position in an axial direction of the reaction chamber corresponding to a substrate-side surface of the first shielding member;
the second position is a position in the axial direction of the reaction chamber corresponding to the center of the substrate; and
the temperatures measured at the first and second positions are in units of °C.

16. The method for producing graphene according to any one of Claims 1 to 5, wherein the reaction chamber has an internal diameter of 12.7 to 38.1 cm.

17. The method for producing graphene according to any one of Claims 1 to 5, wherein the reaction chamber has an internal diameter of 15.24 to 35.56 cm.

18. The method for producing graphene according to any one of Claims 1 to 5, wherein the reaction chamber has an internal diameter of 20.32 to 30.48 cm.

19. The method for producing graphene according to any one of Claims 1 to 5, wherein the reaction chamber comprises silicon dioxide.

20. The method for producing graphene according to any one of Claims 1 to 5, comprising:
accommodating a substrate in the reaction chamber, the substrate comprising a metal film containing at least one metal selected from the group consisting of copper, nickel, and iron;
supplying a source gas containing a hydrocarbon from the gas supply unit into the reaction chamber; and
heating the inside of the reaction chamber to 900 to 1,100°C by the heater, thereby forming graphene on the metal film.
